## Europäisches Patentamt
## European Patent Office
## Office européen des brevets

(19)

(11) Veröffentlichungsnummer: **0 008 038**
**B1**

(12) **EUROPÄISCHE PATENTSCHRIFT**

(45) Veröffentlichungstag der Patentschrift: **18.05.83**

(51) Int. Cl.³: **G 03 F 7/08**

(21) Anmeldenummer: **79102631.3**

(22) Anmeldetag: **25.07.79**

(54) **Verfahren zur Herstellung eines lichtempfindlichen Kopiermaterials auf Basis von Diazoniumsalz-Kondensationsprodukten.**

(30) Priorität: **03.08.78 DE 2834059**

(43) Veröffentlichungstag der Anmeldung:
**20.02.80 Patentblatt 80/4**

(45) Bekanntmachung des Hinweises auf die Patenterteilung:
**18.05.83 Patentblatt 83/20**

(84) Benannte Vertragsstaaten:
**AT BE CH DE FR GB IT NL SE**

(56) Entgegenhaltungen:
**DD - A - 96 345**
**DE - B - 1 105 280**
**FR - A - 1 023 396**
**FR - A - 1 348 383**
**FR - A - 2 302 549**
**GB - A - 851 819**
**NL - A - 292 176**
**NL - A - 7 604 774**
**US - A - 2 500 028**
**US - A - 2 980 534**

(73) Patentinhaber: **HOECHST AKTIENGESELLSCHAFT**
**Postfach 80 03 20**
**D-6230 Frankfurt/Main 80 (DE)**

(72) Erfinder: **Sprintschnik, Gerhard, Dr.**
**Mühlgasse 18**
**D-6238 Hofheim-Wallau (DE)**
Erfinder: **Uhlig, Fritz, Dr.**
**Weinfeldstrasse 1**
**D-6200 Wiesbaden 1 (DE)**

(56) Entgegenhaltungen:
**RESEARCH DISCLOSURE, Nr. 145, Mai 1976,
Seite 15. Homewell, Havant Hampshire (GB)
DOUGLAS C. J. et al. "The use of surfactants to
control both coatability and press performance
of a lithographic layer"
KODAK: "An introduction to photo fabrication
using Kodak photosensitive resists", Seiten
17—19. 1970, Eastman Kodak Co. Rochester
N.Y. (US).**

### Verfahren zur Herstellung eines lichtempfindlichen Kopiermaterials auf Basis von Diazoniumsalz-Kondensationsprodukten

Die Erfindung betrifft ein Verfahren zur Herstellung eines lichtempfindlichen Kopiermaterials aus einem Schichtträger und einer lichthärtbaren Schicht, die ein Diazoniumsalz-Kondensationsprodukt und ein wasserunlösliches makromolekulares Polymerisat enthält. Das Kopiermaterial dient vorzugsweise zur Herstellung von Flachdruckformen und kann nach dem Belichten mit reinem Wasser entwickelt werden.

Ein Kopiermaterial der angegebenen Gattung ist aus der DE—OS 26 26 066 bekannt. Es wird durch Aufbringen einer wäßrigen Dispersion des wasserunlöslichen Polymerisats, die das Diazoniumsalz-Kondensationsprodukt enthält, auf den Schichtträger und Trocknen hergestellt. Die erhaltene Schicht besteht aus einer lichtempfindlichen wasserlöslichen Phase, in der eine lichtunempfindliche wasserunlösliche Phase dispergiert ist. Die Phasengrenzen sind anhand der Konturen der dispergierten Partikel, die in der Größenordnung von 1 $\mu$m liegen, im Mikroskop gut zu erkennen. Die Entwicklung erfolgt mit reinem Wasser, jedoch ist eine mechanische Unterstützung durch Bürsten oder Reiben erforderlich. In der Arbeitsanleitung für ein der Anmeldung entsprechendes Handelsprodukt, das von der Anmelderin der DE—OS angeboten wird, wird zusätzlich die Behandlung mit einem Nachentwickler empfohlen. Eine Entwicklung allein durch Besprühen mit Wasser führt nicht zum Erfolg.

Es sind auch Beschichtungsgemische im Handel, die zur Selbstbeschichtung von Druckplattenträgern durch den Verbraucher bestimmt sind, sogenannte Wipe-On-Systeme. Auch sie enthalten Mischungen von wäßrigen Polymeremulsionen und Diazoniumsalzkondensationsprodukten und werden von Hand auf Schichtträger für Flachdruckplatten aufgetragen und getrocknet. Die erhaltenen lichtempfindlichen Schichten sind jedoch nicht mit reinem Wasser entwickelbar.

Für den Siebdruck sind Gemische aus Kondensationsprodukten von Diazoniumsalzen und wasserlöslichen Polymeren, ggf. unter Zusatz von wasserunlöslichen Polymeren, bekannt. Diese Kopierschichten enthalten einen großen Überschuß an wasserlöslichen Polymeren und sind für den Flachdruck nicht ausreichend oleophil.

In der DE—OS 14 47 957 wird eine vorsensibilisierte Druckplatte beschrieben, die aus einem mit Silikat vorbehandelten Aluminiumträger und einer lichtempfindlichen Schicht besteht, die eine Mischung aus einem wasserunlöslichen, in organischen Lösungsmitteln löslichen Harz und einem wasserlöslichen Diazoniumsalz ist. Die Beschichtung erfolgt aus organischen Lösungsmitteln. Die Lichtempfindlichkeit derartiger Druckplatten ist relativ niedrig, und sie ergeben keine hohen Druckauflagen.

Ein ähnliches Material ist aus der DE—OS 26 07 091 bekannt. Dort wird eine Beschichtungslösung verwendet, die ein wasserunlösliches Diazoharz und ein wasserunlösliches Polymeres in organischem Lösungsmittel sowie ein wasserlösliches oberflächenaktives Mittel enthält. Die Entwicklung der Platte wird mit reinem Wasser durchgeführt, die erzielbare Druckauflage ist jedoch begrenzt.

Aufgabe der Erfindung war es, ein insbesondere für die Herstellung von Druckplatten geeignetes negativ arbeitendes lichtempfindliches Kopiermaterial zu schaffen, das aus wäßrigen Beschichtungsgemischen hergestellt, sauber und schnell auch in feinen Rasterpartien mit reinem Wasser bei Raumtemperatur entwickelt werden kann und Druckformen mit hoher Auflagenleistung ergibt.

Die Erfindung geht aus von einem Verfahren zur Herstellung eines lichtempfindlichen Kopiermaterials, bei dem man ein wäßriges Beschichtungsgemisch, das ein Kondensationsprodukt eines aromatischen Diazoniumsalzes und eine stabile Dispersion eines wasserunlöslichen makromolekularen Polymerisats enthält, auf einen Schichtträger aufbringt und trocknet.

Das erfindungsgemäße Verfahren ist dadurch gekennzeichnet, daß man das Beschichtungsgemisch unter solchen Bedingungen aufbringt und trocknet, daß eine optisch homogene Schicht gebildet wird.

Als optisch homogene Schicht soll in Rahmen dieser Erfindung eine Schicht verstanden werden, deren Oberfläche unter dem Mikroskop völlig homogen erscheint und keine Teilchenstruktur erkennen läßt.

Die Kopiermaterialien lassen sich in technologisch besonders vorteilhafter Weise durch Beschichtung des Schichtträgers mit wäßrigen Dispersionen ohne jeden Zusatz organischer Lösungsmittel herstellen. Sie lassen sich nach der Bildbelichtung durch Besprühen oder Abbrausen mit Wasser ohne jeden Zusatz auch in feinen Rasterpartien sauber entwickeln und ergeben Druckformen mit hoher Auflagenleistung.

Die Kopiermaterialien können als vorsensibilisierte Druckplatten fabrikatorisch produziert oder vom Verbraucher selbst durch Aufbringen der Beschichtungsdispersion auf einen Schichtträger hergestellt werden. Sie können zur Herstellung von Druckplatten, insbesondere von Flachdruckplatten, aber auch von Hoch-, Tief- und Siebdruckformen sowie zur Herstellung von Ätzreserven, z.B. für kopierte Schaltungen, verwendet werden.

Die lichthärtbare Schicht des Kopiermaterials enthält als lichtempfindliche Substanz ein Kondensationsprodukt eines aromatischen Diazoniumsalzes. Derartige Kondensationsprodukte sind bekannt und z.B. in der DE—PS 12 14 086 beschrieben. Sie werden im allgemeinen durch Kondensation einer mehrkernigen aromatischen Diazoniumverbindung, vorzugsweise von substituierten oder unsubstituierten Diphenylamin-4-diazoniumsalzen mit aktiven Carbonyl-verbindungen, vorzugsweise Formaldehyd, in stark saurem Medium, vorzugsweise konzentrierter Phosphorsäure, hergestellt.

In den US—PS 3 867 147 und 4 021 243 sind weitere derartige Kondensationsprodukte beschrieben, die zusätzlich durch Kondensation entstandene Einheiten enthalten, die von Diazoniumsalzgruppen frei sind und vorzugsweise von aromatischen Aminen, Phenolen, Phenoläthern, aromatischen Thioäthern, aromatischen Kohlenwasserstoffen, aromatischen heterocyclischen Verbindungen oder organischen Säureamiden abgeleitet sind.

Von diesen Diazoniumsalz-Kondensationsprodukten werden vor allem die wasserlöslichen Vertreter bevorzugt; es können aber auch die wasserunlöslichen Vertreter nach Überführen in eine stabile, homogene wäßrige Dispersion eingesetzt werden.

Als wasserunlösliche Polymerisate sind grundsätzlich alle Additions- oder Kondensationspolymerisate geeignet, die sich in stabile wäßrige Dispersionen überführen lassen. Besonders vorteilhaft werden die Polymerisate in der Form eingesetzt, wie sie bei der Polymerisation der Monomeren in wäßriger Emulsion anfallen. Beispiele für geeignete wasserunlösliche Polymere sind die Homo- oder Mischpolymerisate von Acryl- und Methacrylsäureestern, z.B. der Methyl-, Äthyl-, Butyl-, Isobutyl-, Hexyl- Decyl-, Lauryl-, Stearyl und Cyclohexylester; von Vinylestern, wie Vinyl- acetat, -propionat, -isononanat, -versatat; von Äthylen, Dibutylmaleinat, Styrol, Vinylchlorid, Vinylisobutyläther, Isobutylen, Butadien oder Vinylbutyral. Ferner sind Polyurethan- und Phenodur-Dispersionen geeignet. Bevorzugt werden Homo- oder Mischpolymerisate von Acryl- und Methacrylsäurealkylestern mit 4 bis 12 Kohlenstoffatomen in der Alkylgruppe, von Vinylalkylestern mit 2 bis 12 Kohlenstoffatomen in der Alkylgruppe oder von Dibutylmaleat, wobei die Mischpolymerisate mindestens zu 50 Mol-% aus Einheiten der genannten Monomeren bestehen sollen.

In geringer Menge können spezielle Comonomere verwendet werden, um der Emulsion spezielle Eigenschaften zu verleihen, z.B. Äthensulfonsäure, N-Methylolacrylamid und polymerisierbare "reaktive" Farbstoffe.

Solche Polymerisatdispersionen sind entweder im Handel erhältlich oder können nach bekannten Vorschriften hergestellt werden.

Die Wasserbeschichtbarkeit und Wasserentwickelbarkeit bei Raumtemperatur kann bei vielen Beschichtungsgemischen durch Zusatz von oberflächenaktiven Substanzen (anionische, kationische, nichtionogene und amphotere) wesentlich verbessert werden. Die günstigste Menge ist bei jedem Polymeren abhängig von der Natur der oberflächenaktiven Substanz und kann jeweils durch einfache Versuche ermittelt werden.

Vorzugsweise werden anionische und nichtionogene Netzmittel eingesetzt. Außerdem wird durch die oberflächenaktiven Substanzen die Beschichtungsqualität auf dem Trägermaterial erheblich verbessert. Störende Schaumbildung kann durch übliche Entschäumer beseitigt werden.

Beispiele für geeignete oberflächenaktive Mittel sind das Dinatriumsalz des Sulfobernsteinsäurehalbesters eines Polyäthylenglykolmonoalkyläthers mit geradkettiger Alkylgruppe mit 10—12 C-Atomen oder eines Polyäthylenglykolmonononylphenoläthers, langkettige Alkylsulfonate, das Natriumsalz des Tristert.- butyl - phenolpolyäthylenglykol - schwefel - säureesters, langkettige Alkylphosphorsäureester, anionisch modifizierte Polyglykoläther, fluorsubstituierte Tenside, Natrium-diisobutylnaphthalinsulfonat und Natriumlaurylsulfat.

Das Kopiermaterial kann auch Schutzkolloide bzw. Verdickungsmittel enthalten (z.B. Polyvinylalkohol, Polyvinylpyrrolidon, Cellulosederivate, Polyvinyl-N-methylacetamid, Polyacrylsäure, Polyacrylsäureamid). Es können auch Mischungen davon zugesetzt werden. Diese Schutzkolloide können bereits zu Beginn der Polymerisation oder auch bei der Herstellung lichtempfindlicher Beschichtungsgemische zugesetzt werden.

Erfindungsgemäß werden vor allem wasserunlösliche Polymere mit Molekulargewichten von 1000 bis 1 000 000 und einer Teilchengröße von ca. 0,05 $\mu$m bis 4,5 $\mu$m eingesetzt. Es können auch durchsichtig erscheinende wasserlösliche Kunstharze (z.B. Resydrole) eingesetzt werden. Die Schichtdicken liegen bevorzugt bei 0,1—0,6 g/m². Dickere Schichten sind möglich, bringen jedoch in kopier- und drucktechnischer Hinsicht keine zusätzlichen Vorteile.

Die lichtempfindliche Schicht des Kopiermaterials enthält im allgemeinen 3 bis 70 Gew.-%, vorzugsweise 7,5 bis 50 Gew.-% Diazoniumsalz-Kondensat, auf das Gewicht der nichtflüchtigen Bestandteile bezogen. Sie enthält ferner 0,1 bis 30, vorzugsweise 0,5 bis 12, Gewichtsteile wasserunlösliches Polymerisat je 1 Gewichtsteil des Diazoniumsalz-Kondensationsprodukts. Die Menge an oberflächenaktivem Mittel beträgt 0—5, vorzugsweise 0,01—0,6, Gewichtsteile, die Menge an Schutzkolloid 0 bis 3, vorzugsweise 0,01—0,5, Gewichtsteile je 1 Gewichtsteil des wasserunlöslichen Polymerisats zusätzlich zu der Menge, die jeweils zur Herstellung und Stabilisierung der Polymerisat-dispersion erforderlich ist, also z.B. der Menge dieser Bestandteile, die in einer handelsüblichen Dispersion enthalten ist.

Den Kopiermaterialien können zusätzlich

Farbstoffe, Weichmacher, Indikatoren und andere Zusätze einverleibt werden. Alle Zusätze sollen so ausgewählt sein, daß sie mit den anderen Schichtbestandteilen verträglich sind und außerdem in Absorptionsbereich der lichtempfindlichen Substanz möglichst wenig absorbieren.

Durch die Erfindung wird es möglich, Kopiermaterialien durch Beschichtung mit rein wäßrigen Beschichtungsgemischen herzustellen. Die belichteten Kopiermaterialien können mühelos mit reinem Wasser, d.h. mit Wasser ohne irgendwelche Zusätze, wie organische Lösungsmittel, Alkalien oder Salze, entwickelt werden.

Im Gegensatz zu den mit Wasser entwickelbaren Druckplatten, die in der DE—OS 26 26 066 beschrieben sind, sind die hier beschriebenen lichtempfindlichen Schichten nicht heterogen, sondern optisch homogen. Selbst bei 30,000-facher Vergrößerung unter dem Raster-Elektronenmikroskop lassen sich keine diskreten Teilchen erkennen. Hingegen lassen sich bei der oben erwähnten heterogenen Schicht bereits bei 1.000-facher Vergrößerung kugelförmige Teilchen erkennen.

Gegenüber diesen bekannten Kopiermaterialien haben die erfindungsgemäß hergestellten Materialien eine höhere Auflösung, und sie lassen sich schneller und leichter mit Wasser entwickeln. Sie haben in der Regel wesentlich geringere Schichtdicken und haben infolgedessen eine höhere Lichtempfindlichkeit. Die Schichten weisen ferner eine ausgezeichnete Oleophilie auf und erreichen hohe Auflagen im Flachdruck. Vorteilhaft ist auch die gute Entwicklerresistenz, z.B. gegenüber 60% igem iso-Propanol, und die harte Gradation der entwickelten Druckplatten.

Zur Herstellung des lichtempfindlichen Kopiermaterials werden die Bestandteile in Wasser gelöst bzw. dispergiert oder vorgefertigte Dispersionen mit Wasser verdünnt. Die erhaltene Dispersion wird auf einen für die Reprographie geeigneten Schichtträger aufgebracht und die aufgetragene Lösung getrocknet. Die Beschichtung kann durch Aufschleudern, Sprühen, Tauchen, Antragen mittels Walzen oder mit Hilfe eines Flüssigkeitsfilms erfolgen und richtet sich auch nach den Eigenschaften des zu beschichtenden Materials. Die Beschichtungslösung sollte bezüglich des dispergierten Polymerisats eine Konzentration im Bereich von etwa 0,1 bis 20, vorzugsweise von 0,5 bis 10, Gew.-% haben. Die richtige Konzentration ist im Einzelfall durch einfache Versuche zu ermitteln. Sie muß so niedrig sein, daß sich die gewünschten Schichtdicken bei gleichmäßigem Schichtauftrag erreichen lassen und daß die in der Schicht enthaltenen dispergierten Polymer-teilchen beim Trocknen unter geeigneten Bedingungen zu einer weitgehend homogenen Schicht verlaufen. Die Wahl einer geeigneten Trocknungstemperatur ist hierfür wichtig. Sie liegt im allgemeinen im Bereich von zwischen 45°C und der Zersetzungstemperatur der Diazoniumverbindung. Die Temperatur hängt im einzelnen von der Art des Trocknungsverfahrens und der Trocknungsdauer ab. Sie soll in jedem Fall hoch genug sein, um—wie oben angegeben—die Ausbildung einer optisch homogenen Schicht zu ermöglichen.

Als Schichtträger sind die verschiedensten Materialien wie Papier, Zink, Magnesium, Aluminium, Chrom, Kupfer, Messing, Stahl und Mehrmetall- oder Kunststoffolien geeignet. Für die Herstellung von Flachdruckplatten wird vorzugsweise mechanisch, chemisch oder mit Hilfe des elektrischen Stroms aufgerauhtes und/oder anodisiertes Aluminium verwendet, das vorteilhaft vor der Sensibilisierung in bekannter Weise mit Phosphonsäuren, insbesondere Polyvinylphosphonsäure, oder mit monomeren oder polymeren Carbonsäuren vorbehandelt worden ist.

Der Zusatz von Farbstoffen oder Sensibilisatoren zu dem Beschichtungsgemisch ist in vielen Fällen vorteilhaft. Geeignete Farbstoffe sind z.B. wasserlösliche Farbstoffe wie Rhodamine, Sudanblau, Methylenblau, Eosin oder Triphenylmethanfarbstoffe wie Kristallviolett, Viktoriareinblau, Malachitgrün, Methylviolett, Fuchsin und Farbpigmente.

Die Belichtung des Kopiermaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen.

Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 $\mu$m emittieren, oder YAG-Laser, die bei 1,06 $\mu$m emittieren.

Die Verarbeitung der Kopiermaterialien bis zur druckbereiten Form geschieht in üblicher Weise. Es wird—wie oben beschrieben—mit Lasern bestrahlt oder unter einer Vorlage belichtet. Während die Schicht an den Stellen, auf die das Licht einwirkt, gehärtet und weitgehend unlöslich wird, werden die unbelichteten, löslich bleibenden Teile der Schicht durch Tauchen und/oder berührungsloses Abbrausen mit Wasser ausgewaschen bzw. entfernt. Die so hergestellte Flachdruckform wird nach der Entwicklung ggf. mit fetter Farbe eingefärbt und mit einem Konservierungsmittel wie Gummi arabicum versehen.

Als Entwickler wird Leitungswasser bevorzugt. Es können aber auch kleine Mengen organischer Lösungsmittel, Netzmittel, Salze, Säuren und dgl. zugesetzt werden.

Die folgenden Beispiele erläutern bevorzugte Ausführungsformen des erfindungsgemäßen verfahrens. Prozentangaben sind, wenn nichts anderes angegeben ist, Gewichtsprozente. Als Gewichtsteil (Gt) ist 1 g zu setzen, wenn als Volumenteil (Vt) 1 ccm gewählt wird.

Beispiel 1

5 Gt einer wäßrigen 20 %igen Emulsion (mit anionischem Emulgatorsystem) von Polyvinylacetat, 0,1 Gt eines polyäthoxylierten Alkylphenols, 2 Gt eines Kondensations-produkts aus 3-Methoxy-diphenylamin-4-diazoniumsalz und Formaldehyd, hergestellt in Phosphorsäure und eingesetzt als Rohkondensationsgemisch, und 0,1 Gt Polyvinylalkohol wurden mit Wasser auf 100 Vt aufgefüllt und auf eine anodisierte und mit Polyvinylphosphonsäure vorbehandelte Aluminiumplatte aufgetragen und etwa 2 Minuten im Konvektionsofen bei 100°C getrocknet. Nach bildmäßiger Belichtung unter einer UV-Lichtquelle wurde die Platte mit Leitungswasser abgespült und mit fetter Schutzfarbe eingefärbt. Sie gab auf einer Multilith-1850-Druckmaschine Auflagen weit über 100.000 Drucke.

Beispiel 2

3 Gt einer wäßrigen 20 %igen Emulsion von Polymethylmethacrylat mit anionischem Emulgatorsystem, 0,5 Gt eines anionisch modifizierten Polyäthylenoxidadduktes, 0,6 Gt Poly-N-vinyl-pyrrolidon, 0,5 Gt des Rohkondensationsprodukts aus Diphenylamin-4-diazoniumsalz und Formaldehyd, hergestellt in konzentrierter Phosphorsäure, 0,25 Gt Fuchsin (C.I. 42 510) und 0,2 Gt Phosphorsäure (85%) wurden mit Wasser auf 100 Vt aufgefüllt und mit einer Plattenschleuder auf trockengebürstetes silikatisiertes Aluminium aufgetragen. Die Schicht wurde 2 Minuten im Konvektionsofen bei 100°C getrocknet. Nach bildmäßiger Belichtung unter einer UV-Lichtquelle wurde die Platte in eine Offsetdruckmaschine eingespannt und darin mit reinem Wasser entwickelt. Die Platte lieferte mehrere 1.000 gute Drucke.

Beispiel 3

10 Gt einer 20 %igen wäßrigen Emulsion von Polyvinylisononanat mit kationischem Hilfssystem, 0,5 Gt des in Beispiel 1 angegebenen polyäthoxylierten Alkylphenols, 2,8 Gt des in Beispiel 1 angegebenen Diazo-Kondensationsprodukts, 0,2 Gt eines Mischkondensationsprodukts aus 1 Mol 3-Methoxy-diphenylamin-4-diazoniumsalz und 1 Mol 4,4'-Bis-methoxymethyl-diphenyläther, hergestellt in 85 %iger Phosphorsäure und isoliert als Methansulfonat, wurden mit Wasser auf 100 Vt aufgefüllt und auf einer Plattenschleuder auf naßgebürstetes, mit einer Mischung von 80 % Polyvinylphosphonsäure und 20 % Vinylphosphonsäure vorbehandeltes Aluminium aufgetragen und etwa 2 Minuten im Konvektionsofen bei 100°C getrocknet. Nach bildmäßiger Belichtung lieferte die Platte an einer Offset-Druckmaschine viele Tausend Drucke.

Beispiel 4

80 Gt einer 40 %igen Polyurethan-Dispersion, 4 Gt des in Beispiel 1 angegebenen polyäthoxylierten Alkylphenols, 8 Gt Ammonium-Alkylpolyoxyäthylensulfat (Alkylgruppe mit 18 C-Atomen), 15 Gt des in Beispiel 1 angegebenen Diazokondensationsprodukts und 2 Gt Kristallviolett (C.I. 42.555) wurden mit Wasser auf 300 Vt aufgefüllt und mit dem Roll-a-coater auf eine anodisierte, mit $K_2ZrF_6$ vorbehandelte Aluminiumfolie aufgetragen. Die Schichtdicke betrug nach dem Trocknen etwa 0,2 g/m². Die Trocknung erfolgte wie in den vorherigen Beispielen. Nach bildmäßiger Belichtung unter einer UV-Lichtquelle wurde mit Leitungswasser abgebraust und mit fetter Schutzfarbe eingefärbt. Die Platte lieferte in einer Offset-Druckmaschine eine Auflage über 100.000.

Beispiel 5

Eine Aluminiumplatte mit einer anodischen Oxidschicht von 1 g/m² wurde mit 0,5 %iger wäßriger Polyvinylphosphonsäurelösung bei 80°C 30 Sekunden vorbehandelt und mit einer lichtempfindlichen Lösung folgender Zusammensetzung beschichtet: 10 Gt einer 20 %igen Emulsion von Polyvinylversatat mit kationischem Dispergiermittel, 1 Gt des in Beispiel 1 angegebenen polyäthoxylierten Alkylphenols, 0,4 Gt Methylviolett (C.I. 42 535), 0,8 Gt des in Beispiel 1 angegebenen Diazokondensationsprodukts, mit Wasser auf 100 Vt aufgefüllt.

Nach bildmäßiger Bestrahlung mit einem 25 Watt Argon-Ionen-Laser im sichtbaren bereich und einer Strahlgeschwindigkeit bis ca. 50 m/s wurden die nicht vom Strahl getroffenen Schichtteile durch Abbrausen mit Leitungswasser entfernt. Die vom Strahl getroffenen Schichtteile sind oleophil gehärtet und nehmen beim Überwischen mit fetter Farbe diese an. Danach kann in einer Offsetdruckmaschine gedruckt werden.

Beispiel 6

40 Gt einer 50 %igen wäßrigen Polyvinylpropionatdispersion und 6 Gt des Beispiel 1 angegebenen polyäthoxylierten Alkylphenols werden unter Rühren mit Wasser auf 1900 Vt aufgefüllt. Dazu wird eine Lösung von 20 Gt des in Beispiel 1 angegebenen Diazokondensationsprodukts in 100 Vt Wasser eingerührt. Mit dieser Mischung wird eine Messing/Chrom-Platte auf einer Schleuder beschichtet und ca. 2 Minuten im Konvektionsofen getrocknet. Nach bildmäßiger Belichtung unter einer UV-Quelle wird mit Leitungswasser abgebraust. Die Platte läßt sich problemlos mit fetter Schutzfarbe einfärben. Gleiche Ergebnisse werden mit einem Aluminium/Kupfer/Chrom-Mehrmetallträger erhalten.

Beispiel 7

5 Gt einer 20 %igen Polyvinylisononanatdispersion mit anionischem Hilfssystem und Polyvinylalkohol als Schutzkolloid, 0,1 Gt des in Beispiel 1 angegebenen polyäthoxylierten Alkylphenols, 2 Gt des in Beispiel 1 angegebenen Diazokondensationsprodukts und 0,5 Gt Kristallviolett werden einige Zeit in ca. 100 Vt Wasser gerührt. Ein handelsübliches Trägermaterial für PapierOffsetdruckplatten wird im Schleuderverfahren mit dieser Lösung beschichtet und ca. 1 Minute im Konvektionsofen getrocknet. Nach bildmäßiger Belichtung und Abreiben mit einem wasserfeuchten Wattetampon läßt sich das Kopiermaterial problemfrei mit fetter Farbe einfärben und ist fertig für die Offsetdruckmaschine.

Beispiel 8

1 Gt eines wasserunlöslichen Mischkondensationsprodukts aus 1 Mol 3-Methoxydiphenylamin-4-diazoniumsalz und 1 Mol 4,4′-Bis-methoxy-methyl-diphenyläther, isoliert als Mesitylensulfonat, 4 Gt eines Alkylsulfattriäthanolammoniumsalzes, 2 Gt einer 50 %igen Dispersion eines Mischpolymerisats aus Vinylacetat und Butylacrylat mit niedermolekularer Hydroxyäthylcellulose als Schutzkolloid und 0,3 Gt Malachitgrün (C.I. 42.000) werden in 100 Vt Wasser intensiv gerührt, bis die Diazoverbindung homogen dispergiert ist. Schleuderbeschichtung auf anodisiertem Aluminiumträger, der mit Polyvinylphosphonsäure vorbehandelt war, ergibt eine sehr lichtempfindliche Druckplatte, die sich durch einfaches Abbrausen mit Leitungswasser problemfrei entwickeln läßt.

Beispiel 9

Eine Mischung aus 16 Gt einer 53 %igen Dispersion eines Mischpolymerisats aus Vinylacetat und Maleinsäuredibutylester, 0,1 Gt des in Beispiel 1 angegebenen polyäthoxylierten Alkylphenols, 0,1 Gt Malachitgrün (C.I. Nr. 42 000), 0,4 Gt einer 40 %igen Dispersion eines grünen Kupferphthalocyaninpigments (C.I. 74 260), 0,6 Gt einer 30 %igen wäßrigen Lösung des in Beispiel 4 angegebenen anionischen Netzmittels, 1 Gt des in Beispiel 1 angegebenen Diazokondensationsprodukts und 100 Vt Wasser wurde auf der Schleuder auf drahtgebürstetes Aluminium (mit Polyvinylphosphonsäure vorbehandelt) aufgebracht. Nach bildmäßiger Belichtung kann die Platte mit Wasser entwickelt werden. Die Platte lieferte mehrere 1.000 gute Drucke.

Beispiel 10

160 Gt einer 22 %igen Polyvinylversatatdispersion mit anionischem Emulgiersystem (langkettiges Alkylsulfonat), 36 Gt des in Beispiel 4 angegebenen anionischen Netzmittels (30 %ige Lösung in Wasser), 10 Gt Malachitgrün (C.I. 42.000), 12 Gt Phosphorsäure (85 %ig), 40 Gt des in Beispiel 3 angegebenen Di - azoniumsalz - Mischkondensations - produkts wurden mit Wasser auf 4000 Vt aufgefüllt und maschinell auf trocken gebürstetes Aluminium (mit Polyvinylphosphonsäure vorbehandelt) beschichtet. Platten mit einer Schichtdicke von 0,4 g/m² waren ausgezeichnet lichtempfindlich und ließen sich nach bildmäßiger Belichtung mit Wasser entwickeln, dem 0.03% eines Na-alkylsulfonats $(C_{16-18})$ zugesetzt worden waren. Bei guter Oleophilie lieferte diese Platte in einer Offsetmaschine mehrere 1.000 Drucke.

**Patentansprüche**

1. Verfahren zur Herstellung eines lichtempfindlichen Kopiermaterials, bei dem man ein wäßriges Beschichtungsgemisch, das ein Kondensationsprodukt eines aromatischen Diazoniumsalzes und eine stabile Dispersion eines wasserunlöslichen makromolekularen Polymerisats enthält, auf einen Schichtträger aufbringt und trocknet, dadurch gekennzeichnet, daß man das Beschichtungsgemisch unter solchen Bedingungen aufbringt und trocknet, daß eine optisch homogene Schicht gebildet wird.

2. Verfahren nach Anspruch 1, dadurch gekennzeichnet, daß man das Beschichtungsgemisch nach dem Aufbringen bei einer Temperatur trocknet, die ausreichend hoch ist, daß eine optisch homogene Schicht gebildet wird.

3. Verfahren nach Anspruch 1, dadurch gekennzeichnet, daß man das Beschichtungsgemisch in ausreichender Verdünnung aufbringt, daß nach dem Trocknen eine optisch homogene Schicht gebildet wird.

4. Verfahren nach Anspruch 1, dadurch gekennzeichnet, daß man ein wasserlösliches Diazoniumsalz-Kondensationsprodukt verwendet.

5. Verfahren nach Anspruch 1, dadurch gekennzeichnet, daß das Beschichtungsgemisch 0,1 bis 30 Gewichtsteile wasserunlösliches Polymerisat je 1 Gewichtsteil des Diazoniumsalz-Kondensationsprodukts enthält.

6. Verfahren nach Anspruch 1, dadurch gekennzeichnet, daß das Beschichtungsgemisch 0,01 bis 0,6 Gewichtsteile eines oberflächenaktiven Mittels je 1 Gewichtsteil des wasserunlöslichen Polymerisats zusätzlich zu der zur Herstellung und Stabilisierung der Dispersion erforderlichen Menge enthält.

7. Verfahren nach Anspruch 1, dadurch gekennzeichnet, daß das Beschichtungsgemisch 0,01 bis 0,5 Gewichtsteile eines Schutzkolloids je 1 Gewichtsteil des wasserunlöslichen Polymerisats zusätzlich zu der gegebenenfalls zur Herstellung und Stabilisierung der Dispersion erforderlichen Menge enthält.

8. Verfahren nach Anspruch 1, dadurch gekennzeichnet, daß das Beschichtungsgemisch 3 bis 70 Gew.-% Diazoniumsalz-Kondensationsprodukt, bezogen auf seine nichtflüchtigen Bestandteile, enthält.

9. Verfahren nach Anspruch 5, dadurch gekennzeichnet, daß das wasserunlösliche Polymerisat ein Homo- oder Mischpolymerisat eines Alkylacrylats oder Alkylmethacrylats mit 4 bis 12 C-Atomen in der Alkylgruppe oder eines Vinylesters oder ein Mischpolymerisat von Dibutylmaleinat ist.

10. Verfahren nach Anspruch 6, dadurch gekennzeichnet, daß das oberflächenaktive Mittel ein anionisches oder nichtionogenes oberflächenaktives Mittel ist.

**Revendications**

1. Procédé de fabrication d'une matière pour photocopie photosensible, dans lequel un mélange aqueux pour couches, contenant un produit de condensation d'un sel de diazonium aromatique et une dispersion stable d'un polymère macro-moléculaire insoluble dans l'eau est appliqué sur un support de couche et séché, caractérisé en ce que le mélange pour couches est appliqué et séché de telle façon qu'il se forme une couche homogène au point de vue optique.

2. Procédé selon la revendication 1 caractérisé en ce que le mélange pour couches est séché après l'application à une température suffisament élevée pour qu'il se forme une couche homogène au point de vue optique.

3. Procédé selon la revendication 1, caractérisé en ce que le mélange pour couches est appliqué à l'état suffisamment dilué pour qu'il se forme après séchage une couche homogène au point du vue optique.

4. Procédé selon la revendication 1, caractérisé en ce qu'on emploie un produit de condensation hydrosoluble d'un sel de diazonium.

5. Procédé selon la revendication 1, caractérisé en ce que le mélange pour couches contient entre 0,1 et 30 parties en poids de polymère insoluble dans l'eau pour chaque partie en poids du produit de condensation du sel de diazonium.

6. Procédé selon la revendication 1, caractérisé en ce que le mélange pour couches contient entre 0,01 et 0,6 parties en poids d'un agent tensio-actif pour chaque partie en poids du polymère insoluble dans l'eau, en complément à la quantité nécessaire pour la fabrication et la stabilisation de la dispersion.

7. Procédé selon la revendication 1, caractérisé en ce que le mélange pour couches contient entre 0,01 et 0,5 parties en poids d'un colloïde de protection pour chaque partie en poids de polymère insoluble dans l'eau en complément à la quantité nécessaire pour la fabrication et la stabilisation de la dispersion.

8. Procédé selon la revendication 1, caractérisé en ce que le mélange pour couches contient entre 3 et 70% en poids de produit de condensation d'un sel de diazonium, calculé par rapport à ses composants non volatils.

9. Procédé selon la revendication 5, caractérisé en ce que le polymère insoluble dans l'eau est un homopolymère ou un copolymère d'un acrylate d'alkyle ou d'un méthacrylate d'alkyle ayant de 4 à 12 atomes de C dans le groupe alkyle, ou d'un ester vinylique ou d'un copolymère de maléate de dibutyle.

10. Procédé selon la revendication 6, caractérisé en ce que l'agent tensio-actif est du type anionique ou non ionique.

**Claims**

1. A process for the manufacture of a light-sensitive copying material, by applying an aqueous coating mixture, which contains a condensation product of an aromatic diazonium salt and a stable dispersion of a water-insoluble macromolecular polymer, to a coating support, and drying the coating, characterized in that the coating mixture is applied, and dried, under such conditions that an optically homogeneous coating is formed.

2. A process as claimed in claim 1, wherein the coating mixture, after application, is dried at a temperature which is sufficiently high that an optically homogeneous coating is formed.

3. A process as claimed in claim 1, wherein the coating mixture is applied in sufficient dilution that after drying an optically homogeneous coating is formed.

4. A process as claimed in claim 1, wherein a water-soluble diazonium salt condensation product is used.

5. A process as claimed in claim 1, wherein the coating mixture contains 0.1 to 30 parts by weight of water-insoluble polymer per part by weight of the diazonium salt condensation product.

6. A process as claimed in claim 1, wherein the coating mixture contains from 0.01 to 0.6 part by weight of a surface-active agent per part by weight of the water-insoluble polymer, over and above the amount of surface-active agent required to manufacture and stabilize the dispersion.

7. A process as claimed in claim 1, wherein the coating mixture contains 0.01 to 0.5 part by weight of a protective colloid per part by weight of the water-insoluble polymer, over and above the amount of protective colloid which may be required to manufacture and stabilize the dispersion.

8. A process as claimed in claim 1, wherein the coating mixture contains 3 to 70% by weight, relative to its non-volatile constituents, of the diazonium salt condensation product.

9. A process as claimed in claim 5, wherein the water-insoluble polymer is a homopolymer or copolymer of an alkyl acrylate or alkyl methacrylate with 4 to 12 C atoms in the alkyl group, or of a vinyl ester, or is a copolymer of dibutyl maleate.

10. A process as claimed in claim 6, wherein the surface-active agent is an anionic or nonionic surface-active agent.